# EUROPÄISCHE PATENTSCHRIFT

(11) **EP 3 983 866 B1**
(45) Veröffentlichungstag und Bekanntmachung des Hinweises auf die Patenterteilung: **09.07.2025**
(21) Anmeldenummer: 20725452.5
(22) Anmeldetag: 05.05.2020
(51) Int. Cl.: G06F 1/16, G09F 9/30, B60K 35/10, B60K 35/22, B60K 35/25, H10K 77/10, H10K 102/00

(54) **TRAGEVORRICHTUNG FÜR EIN DISPLAY MIT SCHALTBARER FLEXIBILITÄT**
SUPPORT DEVICE FOR A DISPLAY HAVING A SWITCHABLE FLEXIBILITY
DISPOSITIF SUPPORT POUR UN AFFICHAGE À FLEXIBILITÉ COMMUTABLE

(30) Priorität: 14.06.2019 DE 102019208725
(43) Veröffentlichungstag der Anmeldung: 20.04.2022
(73) Patentinhaber: Audi AG, 85045 Ingolstadt (DE)
(72) Erfinder: WALL, Christian, 85122 Hitzhofen (DE)
(74) Vertreter: RDL Patentanwälte PartG mbB
(86) Internationale Anmeldenummer: PCT/EP2020/062359
(87) Internationale Veröffentlichungsnummer: WO 2020/249303

(56) Entgegenhaltungen:
- US-A1- 2006 038 745

## Beschreibung

Die vorliegende Erfindung betrifft eine Tragevorrichtung für ein flexibles Display.

In der heutigen Zeit ist die Verwendung von Displays in vielen Umfeldern bekannt. Dabei werden Displays im Allgemeinen fest mit einem Träger und einem Gehäuse starr verbunden. Die neueste Generation von Displays (speziell organische Leuchtdioden, OLED) können jedoch auch flexibel ausgeführt sein.

Aus dem Stand der Technik sind Anzeigevorrichtungen mit flexiblen Displays bekannt.

Aus dem Dokument EP 2 958 098 A1 ist beispielsweise eine Anzeigevorrichtung für digitale Bildinhalte bekannt. Die Anzeigevorrichtung umfasst ein flexibles Display, das auf einem flexiblen, aufblasbaren Träger angeordnet ist, der mittels eines Kompressors aufgeblasen und versteift wird. Der aufgeblasene Träger kann dabei in aufgeblasenem Zustand ein Display tragen.

Aus dem Dokument DE 10 2006 028 049 A1 ist eine Projektionsvorrichtung zur Wiedergabe von visuellen Informationen in einem Fahrzeug bekannt. Eine Anzeigeeinheit der Projektionsvorrichtung ist flexibel ausgeführt und nutzt Schaumstoffelemente, um sich bei Bedarf selbstständig aufzublasen. Bei der Projektionsvorrichtung handelt es sich um eine Projektionsfläche, die aus einem nachgiebigen Material besteht.

Aus dem Dokument DE 10 2006 009 030 B3 sind ein Ballon mit leuchtendem, flächigem Element und ein Herstellverfahren sowie dessen Anwendung bekannt. Ein flexibler Ballon ist dabei oberflächlich mit einer flexiblen Anzeige bestückt, wobei der Ballon vor einer Nutzung mit einem Gas befüllt wird. Es handelt sich somit um die Kombination aus einem Ballon und einem Display. Dabei besteht der Ballon aus einem Material, das Helium besonders lange hält. US 2006 0038 745 A1 offenbart einen Bildschirm mit variabler Steifigkeit für tragbare elektronische Geräte. Der Bildschirm enthält eine flexible elektronische Anzeige, die an ein strukturelles System angeschlossen ist, in dem die physikalischen Eigenschaften von einem flexiblen in einen starren Zustand geändert werden können, um die Steifheit der Anzeige zu steuern. Dabei wird zur Erzielung der Steifigkeit in strukturell angeordnete Leitungen hinter der Oberfläche des Bildschirms Flüssigkeit eingepumpt, wodurch der Bildschirm fest und stabil wird. Um den Bildschirm wieder biegsam zu machen, wird der Flüssigkeitsdruck in den Leitungen wieder reduziert.

Aufgabe der vorliegenden Erfindung ist es, eine Vorrichtung für ein flexibles Display bereitzustellen, dass eine Bedienung des flexiblen Displays erleichtert.

Diese Aufgabe wird durch eine Tragevorrichtung mit den Merkmalen des Patentanspruchs 1 gelöst. Vorteilhafte Weiterbildungen und Ausführungsformen sind Gegenstand der Beschreibung und der Figuren.

Gegenstand der vorliegenden Erfindung ist eine Tragevorrichtung für ein flexibles Display. Das flexible Display ist dabei in der Regel verformbar eingerichtet, insbesondere biegbar, rollbar oder faltbar. Optional kann das flexible Display in einer alternativen Ausführungsform verformbar sein.

Erfindungsgemäß umfasst die Tragevorrichtung einen Grundträger, zumindest eine Begrenzungswand und einen flexiblen Träger, wobei der Grundträger den flexiblen Träger aufnimmt und wobei der flexible Träger von der zumindest einen Begrenzungswand zumindest teilweise begrenzt wird und wobei der flexible Träger dazu ausgebildet ist, das flexible Display darauf anzuordnen. Die erfindungsgemäße Tragevorrichtung bietet den Vorteil, dass eine Tragstruktur für flexible Displays bereitgestellt wird, die derart ausgebildet und eingerichtet ist, dass eine mechanisch schaltbare Flexibilität der Tragevorrichtung erzielt werden kann.

Die Tragevorrichtung umfasst in der Regel zwei Begrenzungswände, die eingerichtet sind, den flexiblen Träger zu begrenzen. Der Grundträger ist eingerichtet, den flexiblen Träger an zumindest zwei Seiten zu umgeben und den flexiblen Träger aufzunehmen. Durch die Begrenzung des flexiblen Trägers sowohl durch den Grundträger als auch durch die zwei Begrenzungswände wird ein Kompressionsraum geschaffen, in dem der flexible Träger komprimierbar ist, da der flexible Träger von allen Seiten begrenzt wird.

In einer Weiterbildung ist eine der Begrenzungswände eingerichtet, das flexible Display aufzunehmen. In einer alternativen Ausführungsform können zumindest zwei Begrenzungswände jeweils zumindest ein flexibles Display aufnehmen. Aufnehmen bedeutet dabei, dass das flexible Display auf die jeweilige Begrenzungswand aufgeklebt oder in einer anderen Weise lösbar oder fest verbunden angebracht ist.

In einer alternativen Ausführungsform ist das flexible Display in die Begrenzungswand eingebracht ausgebildet. Dabei kann die Begrenzungswand eine Aussparung aufweisen, die korrespondierend zu den Maßen des flexiblen Displays ausgebildet ist und eingerichtet ist, das flexible Display zumindest teilweise oder vollständig aufzunehmen.

Der flexible Träger ist als kammerartige Struktur ausgebildet und eingerichtet und weist eine mechanische Flexibilität auf. Die Kammern der kammerartigen Struktur sind eingerichtet, die nötige Flexibilität des Displays zu gewährleisten, um z.B. Biegungen und Verformungen am Display zerstörungsfrei vornehmen zu können. Die kammerartige Struktur weist in der Regel versetzte Hohlraumstrukturen auf. Die einzelnen Hohlräume sind dabei ziegelsteinartig zueinander aufgebaut. Die Hohlräume sind in der Regel stabförmig bzw. länglich ausgebildet.

In einer alternativen Ausführungsform sind die Hohlräume fünf oder sechseckig ausgestaltet und wabenartig zueinander angeordnet. In einer weiteren alternativen Ausgestaltung sind die Hohlräume kreisförmig oder oval ausgestaltet, wobei die kreisförmigen bzw. ovalen Hohlräume versetzt zueinander gestapelt angeordnet sind. In der Regel ist die Struktur des flexiblen Trägers mechanisch flexibel. Das bedeutet, dass die Struktur des flexiblen Trägers verformbar bzw. veränderbar ist.

Die kammerartige Struktur ist komprimierbar.

Komprimierbar bedeutet, dass die kammerartige Struktur zusammendrückbar ist. Dabei können die Hohlräume der kammerartigen Struktur zusammengedrückt werden. In der Regel wird die kammerartige Struktur des flexiblen Trägers mechanisch zusammengedrückt. Dies führt zu einer reversiblen Versteifung der kammerartigen Struktur und damit zu einer reversiblen Versteifung des flexiblen Trägers. In der Regel ist die kammerartige Struktur eingerichtet, bei einer nachlassenden Kompression die ursprüngliche kammerartige Struktur wieder anzunehmen.

Die kammerartige Struktur bietet, unterstützt durch die versetzte Anordnung der Hohlräume, den Vorteil, dass die kammerartige Struktur bei der Kompression einen stabilen Verbund ausbildet. Dadurch bildet der flexible Träger einen harten, steifen Untergrund für das flexible Display aus. Dies bietet den Vorteil, dass durch den festen Untergrund das flexible Display als Touchdisplay bedienbar ist.

In einer Weiterbildung der Erfindung ist die kammerartige Struktur durch eine auf den flexiblen Träger aufgebrachte Kraft komprimierbar. Beispielsweise wird die aufgebrachte Kraft durch einen Kompressor bereitgestellt. Bei der Kompression werden die Wände der kammerartigen Struktur des flexiblen Trägers aufeinander zugeführt bzw. werden die Wände des flexiblen Trägers zusammengedrückt. Der Kompressor bringt somit eine Kraft auf die kammerartige Struktur auf.

Nach einer Beendigung der Kompression ist die kammerartige Struktur eingerichtet, die ursprüngliche Form, die die kammerartige Struktur vor der Kompression aufwies, wieder einzunehmen. Die komprimierbare kammerartige Struktur kann aus einem nachgebendem weichen bzw. flexiblen Material ausgebildet sein. Alternativ kann die komprimierbare kammerartige Struktur aus einer gliederartigen Struktur ausgebildet sein, deren Glieder bei einer Kompression eingerichtet sind, zusammenfaltbar zu sein.

Die mechanische Flexibilität des flexiblen Trägers ist schaltbar eingerichtet, wobei durch eine Schalteinheit der Tragevorrichtung bei einer Kompression des flexiblen Trägers in einen unflexiblen Zustand des flexiblen Trägers geschaltet wird und bei einer Dekompression des flexiblen Trägers in einen flexiblen Zustand des flexiblen Trägers geschaltet wird. Dies bietet den Vorteil, dass für das flexible Display wahlweise in bestimmten Situationen ein steifer Untergrund ausgestaltet werden kann. Ein steifer Untergrund bietet den Vorteil, dass dieser mechanisch stabil ist, um dadurch eine Bedienung des flexiblen Displays zu ermöglichen. Typischerweise ist die Schalteinheit der Tragevorrichtung eingerichtet, den Kompressor zu schalten bzw. zu steuern.

Der flexible Träger ist in unflexiblem Zustand steif und in flexiblem Zustand verformbar. Steif bedeutet dabei, dass der flexible Träger eine derart harte Struktur aufweist, dass eine Touchfunktion des Displays bedienbar ist. Der steife Zustand wird erzielt, indem der flexible Träger komprimiert wird. Verformbar bedeutet, dass der flexible Träger eine veränderbare Struktur aufweist. Diesen Zustand weist die Struktur des flexiblen Trägers in unkomprimiertem Zustand auf.

Die erfindungsgemäße Tragevorrichtung weist insbesondere zwei Zustände auf, den flexiblen und den unflexiblen Zustand. Durch die Wahl zwischen dem flexiblen und dem unflexiblen Zustand ist eine Kombination des flexiblen Displays mit einer Touchbedienung möglich. Dies bietet einen hohen Komfort für einen Fahrzeuginsassen. Beispielsweise ist es möglich, das flexible Display bei einem Nichtgebrauch platzsparend durch Zusammenfalten oder Enrollen zu verstauen. Gleichzeitig bietet der unflexible Zustand die Möglichkeit, bei Bedarf das flexible Display bereitzustellen und zudem eine Touchbedienung des flexiblen Displays zu ermöglichen. Die Notwendigkeit weiterer Bedienelemente entfällt somit, was das Komfortempfinden des Fahrzeuginsassen erhöht.

In einer weiteren Weiterbildung ist der flexible Träger eingerichtet, in dem unflexiblen Zustand zusammen mit dem darauf angeordneten flexiblen Display einen steifen Gesamtverband auszubilden. Durch die Kompression bildet der flexible Träger den unflexiblen Zustand aus, in dem der flexible Träger nicht biegbar bzw. faltbar oder rollbar ist. Zusammen mit dem flexiblen Display bilden der flexible Träger in dem unflexiblen Zustand und das flexible Display den steifen Gesamtverband aus. Der steife Gesamtverband bildet somit ein gerades Display aus, das mechanisch stabil ist und dadurch touchbedienbar ist.

In Ausgestaltung ist das Display als Touchdisplay ausgebildet, wobei das Touchdisplay in dem unflexiblen Zustand des flexiblen Trägers touchbedienbar ist. Durch die Kompression des flexiblen Trägers bildet der flexible Träger den unflexiblen Zustand aus. Dies bietet den Vorteil, dass eine gerade Fläche mit einer Steifigkeit erzielt wird, die derart mechanisch stabil ist, dass diese für eine Touchbedienung nutzbar ist.

In einer Weiterbildung der Erfindung ist die Kompression des flexiblen Trägers aktiv schaltbar. Die Kompression der kammerartigen Struktur wird mittels eines mechanischen Kompressors erzielt. In der Regel ist der Kompressor aktiv schaltbar eingerichtet. Aktiv schaltbar bedeutet, dass der mechanische Kompressor nach Bedarf manuell aktivierbar ist. Dies bietet den Vorteil, dass ein Fahrzeuginsasse aktiv die Kompression des flexiblen Trägers der Tragevorrichtung aktivieren kann, sodass das flexible Display touchbedienbar ist. Alternativ kann die Kompression des flexiblen Trägers automatisch schaltbar eingerichtet sein. Beispielsweise kann bei einem Wechsel zu einer pilotierten Fahrt der flexible Träger automatisch in den unflexiblen Zustand schalten, um die Nutzung für den Fahrzeuginsassen vorzubereiten.

Die Erfindung ist anhand von Ausführungsformen in der Zeichnung schematisch dargestellt und wird unter Bezugnahme auf die Zeichnung weiter beschrieben, wobei gleiche Komponenten mit gleichen Bezugsziffern gekennzeichnet sind. Es zeigt:
- Fig. 1a: einen Querschnitt durch eine Ausführungsform der erfindungsgemäßen Tragevorrichtung mit einem flexiblen Träger in einem flexiblen Zustand,
- Fig. 1b: einen Längsschnitt durch die in - Fig. 1a - gezeigte Ausführungsform der erfindungsgemäßen Tragevorrichtung mit dem flexiblen Träger in dem flexiblen Zustand,
- Fig. 2a: einen Querschnitt durch eine Ausführungsform der erfindungsgemäßen Tragevorrichtung mit einem flexiblen Träger in einem unflexiblen Zustand,
- Fig. 2b: einen Längsschnitt durch die in - Fig. 2a - gezeigte Ausführungsform der erfindungsgemäßen Tragevorrichtung mit dem flexiblen Träger in dem unflexiblen Zustand.

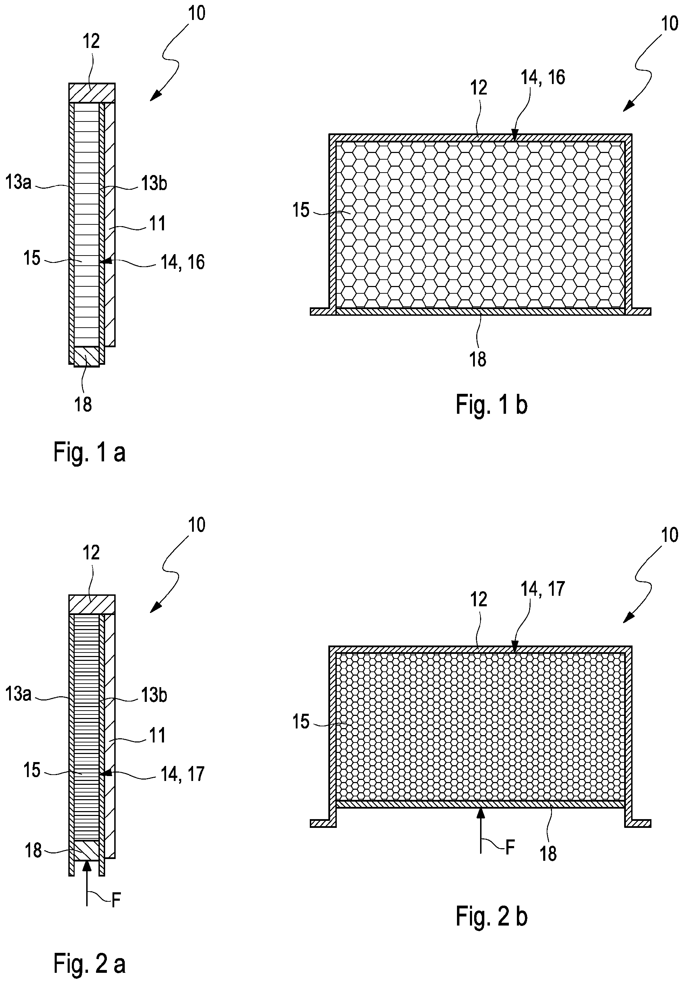

Figur 1a zeigt einen Querschnitt durch eine Ausführungsform der erfindungsgemäßen Tragevorrichtung 10 mit einem flexiblen Träger 14 in einem flexiblen Zustand 16.

Figur 1a zeigt ferner einen Grundträger 12 sowie Begrenzungswände 13a, 13b, das flexible Display 11 und einen Kompressor 18. Der Grundträger 12 nimmt den flexiblen Träger 14 auf und bildet um den flexiblen Träger 14 herum eine Grundstruktur aus. Begrenzt wird der flexible Träger 14 durch die beiden Begrenzungswände 13a und 13b.

**In** der vorliegenden Ausführungsform ist die Begrenzungswand 13b eingerichtet, das flexible Display 11 aufzunehmen. Das flexible Display 11 ist auf die Begrenzungswand 13b aufgebracht.

Der flexible Träger 14 ist kammerartig ausgestaltet bzw. weist zumindest bereichsweise eine kammerartige Struktur 15 auf. Die kammerartige Struktur 15 ist stabförmig ausgestaltet, wobei die stabförmigen Hohlräume ziegelartig aufeinandergelegt angeordnet sind.

Der flexible Träger 14 ist optional aus einem steifen ober biegbaren Material ausgebildet. In der Regel ist der flexible Träger 14 aus einem steifen Material ausgebildet, wobei der flexible Träger 14 durch die kammerartige Struktur 15 eine mechanische Flexibilität erhält bzw. aufweist. Diese mechanische Flexibilität wird durch eine Kompression der kammerartigen Struktur 15 erzielt. Beispielsweise ist die kammerartige Struktur 15 durch eine auf den flexiblen Träger 14 aufgebrachte Kraft komprimierbar.

Die mechanische Flexibilität des flexiblen Trägers 14 ist schaltbar, wobei bei der Kompression des flexiblen Trägers 14 in einen unflexiblen Zustand des flexiblen Trägers 14 geschaltet wird und bei einer Dekompression des flexiblen Trägers 14 in einen flexiblen Zustand 16 des flexiblen Trägers 14 geschaltet wird.

Figur 1b zeigt einen Längsschnitt durch die in - Figur 1a - gezeigte Ausführungsform der erfindungsgemäßen Tragevorrichtung 10 mit dem flexiblen Träger 14 in dem flexiblen Zustand 16. Dabei sind der flexible Träger 14 mit dem Grundträger 12 und der kammerartigen Struktur 15 zu erkennen. Ferner ist der Kompressor 18 dargestellt.

Der Grundträger 12 ist als Aufnahme ausgestaltet, die die kammerartige Struktur 15 an zumindest drei Seiten umgibt. In der vorliegenden Ausführungsform ist der Grundträger 12 rechteckig ausgebildet. In alternativen Ausführungsformen kann der Grundträger 12 eine rundliche, kreisförmige oder ovale Form aufweisen oder eine andere geometrische Form ausbilden.

Figur 2a zeigt einen Querschnitt durch eine Ausführungsform der erfindungsgemäßen Tragevorrichtung 10 mit einem flexiblen Träger 14 in einem unflexiblen Zustand 17.

Figur 2a zeigt ebenfalls - wie in Figur 1a gezeigt - den Grundträger 12 sowie die Begrenzungswände 13a, 13b, das flexible Display 11 und den Kompressor 18. Der Grundträger 12 nimmt den flexiblen Träger 14 auf und bildet die Grundstruktur 12 um den flexiblen Träger 14 herum. Begrenzt wird der flexible Träger 14 durch die beiden Begrenzungswände 13a und 13b.

Die Begrenzungswand 13b nimmt das flexible Display 11 auf, wobei das flexible Display 11 auf die Begrenzungswand 13b aufgebracht ist.

Der flexible Träger 14 ist kammerartig ausgestaltet und weist eine mechanische Flexibilität auf, die durch die Kompression der kammerartigen Struktur 15 mittels des Kompressors 18 erzielt wird.

Die mechanische Flexibilität des flexiblen Trägers 14 ist schaltbar, wobei bei der Kompression des flexiblen Trägers 14 in den unflexiblen Zustand 17 des flexiblen Trägers 14 geschaltet wird und bei der Dekompression des flexiblen Trägers 14 in den flexiblen Zustand 16 des flexiblen Trägers 14 geschaltet wird.

Figur 2b zeigt einen Längsschnitt durch die in - Fig. 2a - gezeigte Ausführungsform der erfindungsgemäßen Tragevorrichtung 10 mit dem flexiblen Träger 14 in dem unflexiblen Zustand 17. Dabei ist der flexible Träger 14 mit dem Grundträger 12 und der kammerartigen Struktur 15 zu erkennen. Ferner ist der Kompressor 18 dargestellt.

Der Grundträger 12 ist als Aufnahme ausgestaltet, die die kammerartige Struktur 15 an zumindest drei Seiten umgibt. In der vorliegenden Ausführungsform ist der Grundträger 12 rechteckig ausgebildet.

Der Kompressor 18 komprimiert den flexiblen Träger 14 mit der Kraft F. Dabei wird der flexible Träger 14 zusammengedrückt und der flexible Träger 14 versteift sich. Zusammen mit dem flexiblen Display 11 bildet der steife, flexible Träger 14 in diesem unflexiblen Zustand einen steifen Gesamtverband, der derart mechanisch stabil ist, dass dieser touchbedienbar ist.

Figur 2b zeigt den flexiblen Träger 14 in dem unflexiblen Zustand 17. Dabei ist die kammerartige Struktur 15 durch den Kompressor mit der Kraft F komprimiert. Durch die Kompression ist der flexible Träger 14 unflexibel, derart, dass sich seine kammerartige Struktur 12 versteift.

Durch die Kompression ist der flexible Träger 14 nicht mehr biegbar bzw. faltbar oder rollbar. Der flexible Träger 14 bildet in dem steifen, unflexiblen Zustand 17 zusammen mit dem flexiblen Display 11 den steifen Gesamtverband aus. Der steife Gesamtverband bildet ein gerades Display 11 aus, das mechanisch stabil ist und dadurch touchbedienbar ist.

Die Kompression des flexiblen Trägers 14 ist aktiv schaltbar. Die Kompression der kammerartigen Struktur 15 wird mittels des mechanischen Kompressors 18 erzielt. Der mechanische Kompressor 18 kann nach Bedarf manuell aktiviert werden. Es besteht somit die Wahl zwischen einem flexiblen Display 11, in einem - in Fig. 1a gezeigten - flexiblen Zustand 16, dass leicht verstaubar ist und einem flexiblen Display 11 in einem unflexiblen Zustand 17, in dem das Display 11 touchbedienbar ist.

### Bezugszeichenliste

- 10: Tragevorrichtung
- 11: flexibles Display
- 12: Grundträger
- 13a, 13b: Begrenzungsbereich
- 14: flexibler Träger
- 15: kammerartige Struktur
- 16: flexibler Zustand
- 17: unflexibler Zustand
- 18: Kompressor
- F: Kraft

## Patentansprüche

1. Tragevorrichtung (10) für ein flexibles Display (11), wobei die Tragevorrichtung (10) einen Grundträger (12), zumindest eine Begrenzungswand (13a, 13b) und einen flexiblen Träger (14) umfasst, wobei der Grundträger (12) den flexiblen Träger (14) aufnimmt und wobei der flexible Träger (14) von der zumindest einen Begrenzungswand (13a, 13b) zumindest teilweise begrenzt wird und wobei der flexible Träger (14) dazu ausgebildet ist, das flexible Display (11) darauf anzuordnen, **dadurch gekennzeichnet, dass** der flexible Träger (14) als kammerartige Struktur (15) ausgebildet und eingerichtet ist und eine mechanische Flexibilität aufweist, wobei die kammerartige Struktur (15) komprimierbar ist, wobei die mechanische Flexibilität des flexiblen Trägers (14) schaltbar eingerichtet ist, wobei durch eine Schalteinheit der Tragevorrichtung (10) bei einer Kompression des flexiblen Trägers (14) in einen unflexiblen Zustand (17) des flexiblen Trägers (14) geschaltet wird und bei einer Dekompression des flexiblen Trägers (14) in einen flexiblen Zustand (16) des flexiblen Trägers (14) geschaltet wird, wobei das Display (11) als Touchdisplay ausgebildet ist, wobei das Touchdisplay in dem unflexiblen Zustand des flexiblen Trägers (14) touchbedienbar ist.

2. Tragevorrichtung nach Anspruch 1, **dadurch gekennzeichnet, dass** eine der Begrenzungswände (13a, 13b) eingerichtet ist, das flexible Display (11) aufzunehmen.

3. Tragevorrichtung (10) nach einem der voranstehenden Ansprüche, **dadurch gekennzeichnet, dass** die kammerartige Struktur (15) durch eine auf den flexiblen Träger (14) aufgebrachte Kraft (12) komprimierbar ist.

4. Tragevorrichtung (10) nach einem der voranstehenden Ansprüche, **dadurch gekennzeichnet, dass** der flexible Träger (14) in unflexiblem Zustand (17) steif und in flexiblem Zustand (16) verformbar ist.

5. Tragevorrichtung (10) nach einem der voranstehenden Ansprüche, **dadurch gekennzeichnet, dass** der flexible Träger (14) eingerichtet ist, in dem unflexiblen Zustand (17) zusammen mit dem darauf angeordneten flexiblen Display (11) einen steifen Gesamtverband auszubilden.

6. Tragevorrichtung (10) nach einem der voranstehenden Ansprüche, **dadurch gekennzeichnet, dass** die Kompression des flexiblen Trägers (14) aktiv schaltbar ist, wobei der mechanische Kompressor nach Bedarf manuell aktivierbar ist.

## Claims

1. A carrier apparatus (10) for a flexible display (11), wherein the carrier apparatus (10) comprises a base carrier (12), at least one boundary wall (13a, 13b) and a flexible carrier (14), wherein the base carrier (12) accommodates the flexible carrier (14) and wherein the flexible carrier (14) is at least partially bounded by the at least one boundary wall (13a, 13b) and wherein the flexible carrier (14) is designed to arrange the flexible display (11) arranged, **characterized in that** the flexible carrier (14) is designed and configured as a chamber-like structure (15) and has a mechanical flexibility, wherein the chamber-like structure (15) can be compressed, wherein the mechanical flexibility of the flexible carrier (14) is configured to be switched, wherein by means of a switching unit of the carrier unit (10), when the flexible carrier (14) is compressed, the flexible carrier (14) is switched to an inflexible state (17) and, when the flexible carrier (14) is decompressed, the flexible carrier (14) is switched to a flexible state (16) of the flexible carrier (14), wherein the display (11) is designed as a touch display, wherein the touch display can be operated by touch in the inflexible state of the flexible carrier (14).

2. The carrier apparatus according to claim 1, **characterized in that** one of the boundary walls (13a, 13b) is configured for accommodating the flexible display (11).

3. The carrier apparatus (10) according to either of the preceding claims, **characterized in that** the chamber-like structure (15) can be compressed by a force (12) applied to the flexible carrier (14).

4. The carrier apparatus (10) according to any of the preceding claims, **characterized in that** the flexible carrier (14) is rigid in the inflexible state (17) and deformable in the flexible state (16).

5. The carrier apparatus (10) according to any of the preceding claims, **characterized in that** the flexible carrier (14), together with the flexible display (11) arranged on it, is configured to form a rigid overall system in the inflexible state (17).

6. The carrier apparatus (10) according to any of the preceding claims, **characterized in that** the compression of the flexible carrier (14) can be actively switched, wherein the mechanical compressor can be activated manually if required.

## Revendications

1. Dispositif de support (10) pour un écran flexible (11), le dispositif de support (10) comprenant un support de base (12), au moins une paroi de délimitation (13a, 13b) et un support flexible (14), le support de base (12) recevant le support flexible (14) et le support flexible (14) étant délimité au moins partiellement par la au moins une paroi de délimitation (13a, 13b) et le support flexible (14) étant conçu pour y placer l'écran flexible (11), **caractérisé en ce que** le support flexible (14) est réalisé et configuré comme une structure en forme de chambre (15) et présente une flexibilité mécanique, la structure en forme de chambre (15) étant compressible, la flexibilité mécanique du support flexible (14) étant commutable, une unité de commutation du dispositif de support (10) permettant de commuter à un état non flexible (17) du support flexible (14) lors d'une compression du support flexible (14) et à un état flexible (16) du support flexible (14) lors d'une décompression du support flexible (14), l'écran (11) étant réalisé sous la forme d'un écran tactile, l'écran tactile pouvant être commandé tactilement lorsque le support flexible (14) est dans l'état non flexible.

2. Dispositif de support selon la revendication 1, **caractérisé en ce qu'**une des parois de délimitation (13a, 13b) est configuré pour recevoir l'écran flexible (11).

3. Dispositif de support (10) selon l'une des revendications précédentes, **caractérisé en ce que** la structure en forme de chambre (15) est compressible par une force (12) appliquée sur le support flexible (14).

4. Dispositif de support (10) selon l'une des revendications précédentes, **caractérisé en ce que** le support flexible (14) est rigide à l'état non flexible (17) et déformable à l'état flexible (16).

5. Dispositif de support (10) selon l'une des revendications précédentes, **caractérisé en ce que** le support flexible (14) est configuré pour former, dans son état non flexible (17), un ensemble rigide avec l'écran flexible (11) disposé dessus.

6. Dispositif de support (10) selon l'une des revendications précédentes, **caractérisé en ce que** la compression du support flexible (14) est commutable activement, le compresseur mécanique pouvant être activé manuellement au besoin.
